# EUROPÄISCHE PATENTANMELDUNG

(11) **EP 4 831 654 A1**
(43) Veröffentlichungstag der Anmeldung: **28.10.2026**
(21) Anmeldenummer: 26164273.0
(22) Anmeldetag: 12.03.2026
(51) Int. Cl.: G01R 29/08

(54) **PRÜFSTAND FÜR ACHSANTRIEBE ZUR UNTERSUCHUNG DEREN ELEKTROMAGNETISCHER VERTRÄGLICHKEIT**

(30) Priorität: 21.03.2025 DE 102025110991
(71) Anmelder: Huellmandel, Steven, 92699 Bechtsrieth (DE)
(72) Erfinder: Huellmandel, Steven, 92699 Bechtsrieth (DE)
(74) Vertreter: Benninger, Johannes

(57) **Zusammenfassung**

Die Erfindung offenbart einen Prüfstand (10) zur Untersuchung der elektromagnetischen Verträglichkeit von Achsantriebsgruppen (12).

Die Achsantriebsbaugruppe (12) umfasst eine auf einem Prüfplatz (28) fixierte angetriebene Achseinheit (14) eines Fahrzeuges mit angebauter Getriebeeinheit (18), einen mit der Achseinheit (14) gekoppelten elektromotorischen Antrieb (22) sowie eine mit diesem gekoppelte Leistungselektronik (24), wobei die angetriebene Achseinheit (14) mit der angebauten Getriebeeinheit (18), dem elektromotorischen Antrieb (22) sowie der Leistungselektronik (24) einen Prüfling (26) bildet, dessen elektromagnetische Verträglichkeit auf dem Prüfstand (10) zu untersuchen ist

Der Prüfstand (10) mitsamt dem Prüfplatz (28) ist innerhalb eines definierten abgeschirmten räumlichen Bereiches (42) angeordnet.

Die Achsantriebsgruppe (12) ist abtriebsseitig mit Belastungsmaschinen (32) zur Simulierung eines Antriebswiderstandes für die Achsantriebsgruppe (12) gekoppelt. Dem Prüfstand (12) ist eine Antenne (40) zur Erfassung der elektromagnetischen Emissionen des Prüflings (26) während eines Prüfstandlaufes zugeordnet.

Der gesamte Prüfstand (10) ist mit dem darin angeordneten Prüfplatz (28) und mit dem dort fixierten Prüfling (26) mitsamt den Belastungsmaschinen (32) rotierbar, insbesondere in Bezug auf die Antenne (40).

## Beschreibung

Die vorliegende Erfindung betrifft einen Prüfstand zur Untersuchung der elektromagnetischen Verträglichkeit von Achsantriebsgruppen.

Komplexe Maschinenkonfigurationen können die unterschiedlichsten elektrischen und elektronischen Komponenten umfassen, was es in der Regel notwendig macht, nicht nur die EMV-Verträglichkeit dieser Komponenten zu prüfen, sondern auch das Verhalten der Gesamtkonfigurationen hinsichtlich ihres EMV-Verhaltens zu kennen und Nachweise zu führen, dass die komplexe Maschinenkonfiguration auch im Zusammenspiel ihrer einzelnen Komponenten gleichermaßen immun gegen externe Störungen ist. Bei derartigen EMV-Prüfungen ist der Nachweis zu führen, dass die Maschinenkonfiguration in elektromagnetischer Hinsicht verträglich ist, d.h. immun gegenüber externen Störungen, wie sie durch Funkwelleneinstrahlungen auftreten können. Zudem ist mit einer derartigen EMV-Prüfung der Nachweis zu führen, dass die Maschinenkonfiguration möglichst frei ist von Störaussendungen, die andere Komponenten beeinflussen könnten. Hinzu kommt die Überprüfung der Wirksamkeit von konstruktiven Abschirmungsmaßnahmen.

Bekannte Prüfanordnungen sehen Messungen mittels Antenne vor, bei der ein definierter Abstand zwischen einem Prüfling und einer Antenne eingestellt und verschiedene Frequenzbereiche durchmessen werden, um insbesondere die Störfestigkeit und die Störaussendung des Prüflings für unterschiedliche Frequenzen und/oder Antennenpositionen festzustellen und nachzuweisen.

Ein häufiges Anwendungsfeld für solche elektromagnetische Verträglichkeitsprüfungen sind elektrifizierte Antriebsstränge von Fahrzeugen, die entweder mit reinen Elektroantrieben oder mit sog. Hybridantrieben, d.h. kombinierten elektrischen und verbrennungsmotorischen Antrieben, ausgestattet sein können. Um einen solchen Antriebsstrang oder bspw. nur eine Antriebseinheit mit einigen damit zusammenwirkenden Antriebs- und Steuerungskomponenten einer EMV-Prüfung zu unterziehen, werden die Antriebskomponenten üblicherweise in einer abgeschirmten Prüfkammer positioniert und einer Belastungssimulation unterzogen, während mittels sinnvoll innerhalb der Prüfkammer positionierter Antennen die EMV-Prüfungen durchgeführt werden.

So offenbart die DE 10 2021 134 125 B4 eine Prüfanordnung und ein Prüfverfahren zur Prüfung der elektromagnetischen Verträglichkeit einer Achsantriebsbaugruppe mit elektrischen Antriebskomponenten, indem Störaussendungen und/oder eine Störfestigkeit gemessen werden. Hierbei umfasst die zu untersuchende Achsantriebsbaugruppe einen elektrischen Achsantrieb und zwei damit antreibbare Abtriebswellen, die an Abgängen des Achsantriebes angebracht sind. Der Achsantrieb kombiniert einen Elektromotor, ein Getriebe und eine Leistungselektronik in einer Einheit, die zum unmittelbaren Antrieb der Fahrzeugachse ausgebildet ist. Die Achsantriebsbaugruppe bildet einen Prüfling, der in einer Prüfkammer platziert wird, wobei der Prüfling in einer Weise auf einem Prüftisch fixiert ist, dass eine Messachse einer in der Prüfkammer angeordneten Antenne im Wesentlichen senkrecht zum Prüfling oder zum Prüfaufbau positioniert ist, wobei die gesamte Breite der Achsantriebsbaugruppe einschließlich der Abgänge und der Abtriebswellen zur Antenne zeigt. Weiterhin ist bei dieser bekannten Prüfanordnung vorgesehen, dass jede der beiden Abtriebswellen über ein innerhalb der Prüfkammer angeordnetes Winkelgetriebe an eine außerhalb der Prüfkammer angeordnete Lastmaschine angeschlossen ist, wodurch die beiden Abtriebswellen und die Antriebswelle zwischen der externen Lastmaschine und dem Achsantrieb nicht koaxial zueinander verlaufen.

Derartige Prüfstände erlauben es zwar, die meisten benötigten Messungen in zufriedenstellender Weise durchzuführen, erfordern aber einen vergleichsweise hohen Aufwand, sollen unterschiedliche Achsantriebsbaugruppen und insbesondere unterschiedlich dimensionierte Baugruppen gleichermaßen geprüft werden, denn der Umbauaufwand hierfür ist erheblich. Als nachteilig bei solchen Prüfständen erweist es sich zudem, dass unterschiedliche Ausrichtungen des Prüflings zur innerhalb der Prüfkammer angeordneten Antenne ebenfalls einen erhöhten Umbauaufwand erfordern, da die Antennen meist ortsfest innerhalb der Prüfkammer positioniert sind.

Angesichts des bekannten Standes der Technik kann es als ein vorrangiges Ziel der Erfindung betrachtet werden, einen Prüfstand dahingehend zu verbessern, dass er sowohl hinsichtlich der handhabbaren Dimensionen der zu untersuchenden Prüflinge als auch hinsichtlich der messtechnisch erfassbaren Positionen der Prüflinge möglichst variabel ist.

Dieses Ziel wird durch die Gegenstände der unabhängigen Ansprüche erreicht. Weitere vorteilhafte Ausgestaltungen werden durch die Unteransprüche beschrieben.

Zur Erreichung des genannten Ziels schlägt die vorliegende Erfindung einen Prüfstand zur Untersuchung der elektromagnetischen Verträglichkeit von Achsantriebsgruppen vor, wobei diese Achsantriebsgruppe zumindest eine auf einem Prüfplatz fixierte angetriebene Achseinheit eines Fahrzeuges mit angebauter Getriebeeinheit, einen mit der Achseinheit gekoppelten elektromotorischen Antrieb sowie eine mit diesem gekoppelte Leistungselektronik umfasst. Die angetriebene Achseinheit bildet mit der angebauten Getriebeeinheit, der elektromotorische Antrieb sowie die Leistungselektronik einen Prüfling, dessen elektromagnetische Verträglichkeit auf dem Prüfstand untersucht werden kann.

Der Prüfstand mitsamt dem Prüfplatz befindet sich innerhalb eines definierten abgeschirmten räumlichen Bereiches, so dass effektive EMV-Messungen ohne äußere Störeinflüsse ermöglicht sind.

Zur Simulation von Belastungssituationen für die EMV-Messungen ist die Achsantriebsgruppe abtriebsseitig mit Belastungsmaschinen zur Simulierung eines Antriebswiderstandes für die Achsantriebsgruppe gekoppelt, wobei es sich bei den Belastungsmaschinen sinnvollerweise um steuerbare Elektromotoren handelt. Zudem ist dem Prüfstand mindestens eine ortsfeste oder ortsveränderlich angeordnete Antenne zur Erfassung der elektromagnetischen Emissionen des Prüflings während eines Prüfstandlaufes zugeordnet. Mindestens eine solche Antenne ist zur Durchführung der EMV-Prüfungen erforderlich, wobei es für spezifische Messläufe ggf. auch sinnvoll sein kann, mit mehreren Antennen zu arbeiten. Da die elektromagnetische Wechselwirkung zwischen dem am Prüfstand befindlichen Prüfling und der mindestens einen Antenne erfasst werden soll, ist die mindestens eine Antenne zwar dem Prüfstand räumlich zugeordnet, befindet sich aber nicht unmittelbar innerhalb des Prüfstandes, sondern vorzugsweise an dessen äußerem Rand.

Die Erfindung sieht vor, dass der gesamte Prüfstand mit dem darin angeordneten Prüfplatz und mit dem dort fixierten Prüfling mitsamt den Belastungsmaschinen rotierbar ist, insbesondere in Bezug auf die randseitig am Prüfstand angeordnete Antenne.

Je nach benötigtem Messaufbau kann bei dem Prüfstand eine ortsfeste Antenne vorgesehen sein, die sich randseitig am Prüfstand oder außerhalb des Prüfstandes befinden kann. Wahlweise können auch mehrere Antennen vorgesehen sein, die an unterschiedlichen Positionen randseitig am Prüfstand und/oder außerhalb des Prüfstandes vorgesehen sein können.

Bei einer weiteren Ausführungsvariante des erfindungsgemäßen Prüfstandes kann auch mindestens eine Antenne ortsveränderlich in Bezug auf den Prüfstand angeordnet sein.

Als besonderer Vorteil des erfindungsgemäßen Prüfstandes erweist es sich, dass dieser komplett gekapselt bzw. elektromagnetisch abgeschirmt ausgestaltet ist und dass er mitsamt seiner Schirmung rotierbar ist.

Diese Rotierbarkeit des Prüfstandes meint eine Rotationsmöglichkeit um eine vertikale Achse.

Vorzugsweise sind auch die Belastungsmaschinen auf dem Prüfstand ortsveränderlich, so dass eine Anpassung des gesamten Prüfstandes an unterschiedlich dimensionierte oder unterschiedlich breite Achseinheiten mit unterschiedlich positionierten Ausgängen für die Abtriebswellen ermöglicht ist.

So können die Belastungsmaschinen jeweils beidseitig am Prüfplatz und in den Abständen zu diesem veränderlich angeordnet sein.

Die Rotierbarket des Prüfstandes kann bspw. durch einen rotierbaren Drehteller realisiert sein, wobei der auf dem Prüfplatz befindliche Prüfling mitsamt den Belastungsmaschinen auf dem rotierbaren Drehteller positioniert sein können, wodurch die gewünschte Variabilität des erfindungsgemäßen Prüfstandes gegeben ist.

Die Belastungsmaschinen können insbesondere auf dem rotierbaren Drehteller als ortsveränderliche Teile des Prüfstandes ausgestaltet sein. So kann etwa vorgesehen sein, dass die Belastungsmaschinen variabel auf dem Drehteller positionierbar sind, wobei sie insbesondere in ihrem Abstand zueinander und/oder in ihren jeweiligen Abständen zum Prüfplatz veränderlich sind, womit sich der Prüfstand weitgehend an alle unterschiedlichen Notwendigkeiten hinsichtlich unterschiedlicher Dimensionen unterschiedlicher Prüflinge anpassen lässt, ohne dass er in seinen Funktionalitäten eingeschränkt ist.

Vorzugsweise sind die Belastungsmaschinen gut geschirmt, um solchermaßen jegliche Störungen, die auf die Antenne wirken, zu reduzieren oder auszuschließen.

Außerdem befindet sich vorzugsweise die ganze Leistungselektronik und zugehörige Komponenten innerhalb der Schirmung und bildet solchermaßen einen Teil des Prüfstandes. Auch bei dieser Leistungselektronik ist es erforderlich, diese möglichst gut abzuschirmen, um auch hierbei jegliche Störungen, die auf die Antenne wirken können, weitestgehend zu vermeiden.

Insgesamt ist es erforderlich, alle potentiell störenden Teile des Prüfstandes gut abzuschirmen, so dass sie elektromagnetisch neutral sind und die Prüfstandversuche möglichst wenig stören können.

Weiterhin kann bei einer sinnvollen Ausführungsvariante des erfindungsgemäßen Prüfstandes vorgesehen sein, dass ein Unterbau des Prüflings zumindest in wesentlichen Anteilen durch mineralisches Material gebildet ist oder zu wesentlichen Anteilen mineralisches Material umfasst. Dieser Unterbau des Prüflings bildet einen stützenden Bestandteil des Prüfplatzes und befindet sich insbesondere zwischen dem Prüfling und dem rotierbaren Drehteller. Der Unterbau kann bspw. durch Aufstandsfüße o. dgl. stützende Bauteile gebildet sein. Es kann von Vorteil sein, wenn dieser Unterbau zumindest in wesentlichen Anteilen durch mineralisches Material gebildet ist oder zu wesentlichen Anteilen mineralisches Material umfasst.

Außerdem kann bei dem erfindungsgemäßen Prüfstand auch ein Unterbau mindestens einer der Belastungsmaschinen zumindest in wesentlichen Anteilen durch mineralisches Material gebildet sein oder zu wesentlichen Anteilen mineralisches Material umfassen. Dieser weitere Unterbau der mindestens einen Belastungsmaschine bildet einen stützenden Bestandteil dieser mindestens einen Belastungsmaschine und befindet sich somit insbesondere zwischen der Belastungsmaschine und dem rotierbaren Drehteller. Der Unterbau kann insbesondere durch einen Antriebsturm gebildet sein oder kann einen Teil dieses Antriebsturmes bilden. Vorzugsweise weist jede Belastungsmaschine - dies können typischerweise mindestens zwei an der Zahl sein - einen solchen Unterbau auf, der zumindest in wesentlichen Anteilen durch mineralisches Material gebildet ist oder zu wesentlichen Anteilen mineralisches Material umfasst.

Eine derartige Materialauswahl für den Unterbau des Prüflings und/oder für den Unterbau der mindestens einen Belastungsmaschine oder jeder vorhandenen Belastungsmaschine kann für eine möglichst geringe elektromagnetische Permittivität der entsprechenden stützenden Bestandteile des Prüfstandes sorgen, so dass sich für diese Teile eine relativ gering ausgeprägte Wechselwirkung mit dem innerhalb des Prüfstandes erzeugten elektromagnetischen Feld ergibt. Das mineralische Material kann bspw. durch Kalkstein wie etwa Marmor, durch Granit, durch Mineralglas oder durch ein geeignetes mineralisches Sinter- oder Gussmaterial gebildet sein, das über die notwendige Stabilität und gleichzeitig für die gewünschte geringe elektromagnetische Permittivität verfügt.

Bei einer weiteren vorteilhaften Ausführungsvariante des erfindungsgemäßen Prüfstandes kann der Prüfplatz einen Prüftisch umfassen, auf dem sich der Prüfling befindet, wobei der Prüftisch insbesondere über den Unterbau des Prüflings verfügt oder auf dem genannten Unterbau des Prüflings aufliegt. Der Prüfling kann somit auf dem Prüftisch befestigt oder aufgespannt werden. Von Vorteil ist es, wenn der Prüftisch eine elektromagnetisch und elektrisch leitende Grundplatte umfasst, die als elektrisch leitende Erdungsplatte für den Prüfling fungieren kann. So kann der Prüftisch, der den Aufspanntisch für den Prüfling bildet, bspw. über eine solide Stahlplatte o. dgl. metallische Platte verfügen. Weiterhin kann es von Vorteil sein, wenn dieser Prüftisch oder Aufspanntisch wechselbar auf dem durch mineralisches Material gebildeten Unterbau befestigt werden kann, was allfällige Rüstvorgänge beschleunigen und vereinfachen kann.

Im Folgenden sollen Ausführungsbeispiele die Erfindung und ihre Vorteile anhand der beigefügten Figuren näher erläutern. Die Größenverhältnisse der einzelnen Elemente zueinander in den Figuren entsprechen nicht immer den realen Größenverhältnissen, da einige Formen vereinfacht und andere Formen zur besseren Veranschaulichung vergrößert im Verhältnis zu anderen Elementen dargestellt sind.
Fig. 1 zeigt eine schematische Darstellung eines Prüfstandes mit seinen wichtigsten Komponenten.
Figuren 2 bis 5 zeigen in schematischen und perspektivischen Darstellungen eine Ausführungsvariante eines erfindungsgemäßen Prüfstandes.
Figuren 6 und 7 zeigen in schematischen und perspektivischen Darstellungen weitere Ausführungsvarianten des erfindungsgemäßen Prüfstandes.

Für gleiche oder gleich wirkende Elemente der Erfindung verwendet die nachfolgende Figurenbeschreibung in der Regel jeweils gleiche Bezugsziffern. Ferner werden der Übersicht halber in vielen Fällen nur solche Bezugsziffern in den einzelnen Figuren verwendet, die für die Beschreibung der jeweiligen Figur erforderlich sind. Die dargestellten Ausführungsformen stellen lediglich Beispiele dar, wie der erfindungsgemäße Prüfstand ausgestaltet sein kann und stellen keine abschließende Begrenzung dar. Auch sind die nachfolgend beschriebenen Merkmale jeweils nicht in engem Zusammenhang mit weiteren Merkmalen des jeweiligen Ausführungsbeispiels zu verstehen, sondern können jeweils im allgemeinen Zusammenhang vorgesehen sein bzw. hierfür Verwendung finden.

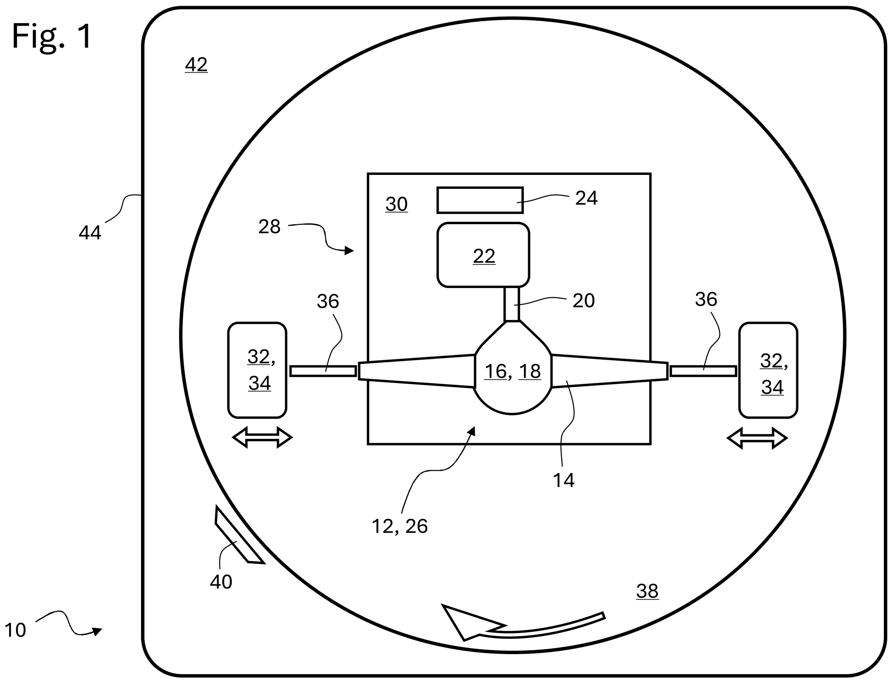

Die schematische Draufsicht der Fig. 1 verdeutlicht die wesentlichen Komponenten des erfindungsgemäßen Prüfstandes 10, der für eine Untersuchung der elektromagnetischen Verträglichkeit einer Achsantriebsgruppe 12 vorbereitet und entsprechend ausgestattet ist. Eine für den Einbau in einem Fahrzeug vorgesehene Achseinheit 14 kann bspw. als herkömmlich aufgebaute starre Antriebsachse ausgebildet sein, wie sie typischerweise in Lastkraftwagen zum Einsatz kommen. Die Achseinheit 14 enthält in diesem Fall ein Differenzialgetriebe 16, was hier auch als Getriebeeinheit 18 bezeichnet sein soll.

Die Achseinheit 14 ist über eine mit dem Differenzialgetriebe 16 bzw. der Getriebeeinheit 18 gekoppelte Antriebswelle 20 mit einem elektromotorischen Antrieb 22 gekoppelt, der somit entweder den Achsantrieb bildet oder der als Ersatz für einen Getriebeausgang eines Verbrennungsmotors (nicht gezeigt) dienen kann. Außerdem ist dem elektromotorischen Antrieb 22 eine Leistungselektronik 24 zugeordnet, die mit dem elektromotorischen Antrieb 22 gekoppelt ist, um seinen Betrieb steuern zu können.

Die solchermaßen angetriebene Achseinheit 14 bildet zusammen mit der angebauten Getriebeeinheit 18, dem elektromotorischen Antrieb 22 sowie der Leistungselektronik 24 einen Prüfling 26, dessen elektromagnetische Verträglichkeit auf dem Prüfstand 10 zu untersuchen ist, was nachfolgend in knapper Form beschrieben werden soll. Der aus den genannten Komponenten gebildete Prüfling 26 befindet sich auf einem Prüfplatz 28 montiert, der bspw. durch einen Prüftisch 30 o. dgl. gebildet sein kann, wie dies in Fig. 1 schematisch angedeutet ist.

Weiterhin ist die Achseinheit 14 der Achsantriebstruppe 12 abtriebsseitig mit Belastungsmaschinen 32 gekoppelt, mit denen Antriebswiderstände generiert werden können, um solchermaßen einen Fahrbetrieb für die Achsantriebsgruppe 12 simulieren zu können. Die Belastungsmaschinen 32 sind insbesondere jeweils mit steuerbaren Elektromotoren 34 ausgestattet, die über Abtriebswellen 36 mit den Ausgängen der Achseinheit 14 gekoppelt sind. Die als Bremsmotoren wirkenden Elektromotoren 34 der Belastungsmaschinen 32 ersetzen somit die Antriebsräder eines realen Fahrzeuges, die in realen Fahrsituationen bspw. auf wechselndem Untergrund abrollen würden, inklusive Steigungen, Gefälle und wechselnden Rollwiderständen, was mittels der steuerbaren Belastungsmaschinen 32 zu simulieren ist.

Der gesamte Prüfstand 10 mit dem Prüfplatz 28 und den beidseitig am Prüfling 26 befindlichen und mit dem Prüfling 26 gekoppelten Belastungsmaschinen 32 kann sich insbesondere auf einem rotierbaren Drehteller 38 befinden, der um eine zentrale vertikale Drehachse rotiert werden kann, um insbesondere unterschiedliche Positionen des Prüfstandes 10 gegenüber einer ortsfesten Antenne 40 einstellen zu können, so dass die unterschiedlichsten Messsituationen für den Prüfling 26 hergestellt und die unterschiedlichsten EMV-Messungen durchgeführt werden können.

Die Rotierbarkeit des Drehtellers 38 ist durch einen gekrümmten Pfeil angedeutet, der sich im unteren Bereich des Drehtellers 38 befindet; wahlweise kann die Drehbarkeit in beide Richtungen gegeben sein. Außerdem bezieht sich die Rotierbarkeit des Drehtellers 38 auf eine hier nicht dargestellte vertikale Achse, die sich im Mittelpunkt des Drehtellers 38 befindet.

Der gesamte Prüfstand 10 mit allen erwähnten Komponenten des Prüfplatzes 28 sowie den damit verbundenen oder zusammenwirkenden weiteren Bestandteilen befindet sich innerhalb eines definierten abgeschirmten räumlichen Bereiches 42, in dem die Messungen durchgeführt werden können. Die Abschirmung 44 dieses räumlichen Bereiches 42 sorgt dafür, dass die durchgeführten Messungen nicht durch externe Einflüsse verfälscht werden. Die Rotierbarkeit des Drehtellers 38 mitsamt den darauf befindlichen Komponenten ermöglicht es, den Prüfling 26 in unterschiedlichen Ausrichtungen zur Antenne 40 den gewünschten Messungen zu unterziehen.

Der definierte abgeschirmte räumliche Bereich 42 kann auch als EMV-Halle betrachtet werden oder durch eine EMV-Halle gebildet sein. Während bei bekannten Prüfständen die Antriebsmaschinen normalerweise außerhalb einer solchen EMV-Halle positioniert sind, um ihr elektromagnetisches Störpotential zu eliminieren, befindet sich beim erfindungsgemäßen Prüfstand 10 der elektromotorische Antrieb 22 unmittelbar am Prüfling 26, muss aber in diesem Fall so gut abgeschirmt sein, dass keine störende elektromagnetische Strahlung aus dieser Abschirmung in die Messumgebung gelangen kann.

Gleiches gilt grundsätzlich für die Belastungsmaschinen 32, die bei bekannten Prüfständen meist außerhalb der EMV-Halle positioniert sind, damit auch hier ihr elektromagnetisches Störpotential nicht wirksam werden kann. Im Gegensatz hierzu befinden sich die Belastungsmaschinen 32 beim erfindungsgemäßen Prüfstand 10 nahe am Prüfling 26, so dass auch diese Belastungsmaschinen 32 im vorliegenden Fall so gut abgeschirmt sein müssen, dass von ihnen keine störende elektromagnetische Strahlung abgestrahlt und in den abgeschirmten räumlichen Bereich 42 der EMV-Halle, d.h. in die Messumgebung, eingeleitet werden kann.

Beim erfindungsgemäßen Prüfstand 10 ist es weiterhin sehr vorteilhaft, dass die Belastungsmaschinen 32 auf dem Drehteller 38 in horizontaler Richtung beweglich gelagert sein können, um ihren jeweiligen Abstand zum Prüfling 26 variieren zu können. Auf diese Weise kann der Prüfstand 10 leicht auf unterschiedliche Prüflinge 26, gebildet insbesondere durch unterschiedlich große Achseinheiten 14 mit unterschiedlichen Abständen ihrer Abtriebswellen 36 voneinander, angepasst werden, ohne dass hierfür aufwendige Umbaumaßnahmen notwendig wären. Durch eine entsprechende Dimensionierung des Drehtisches 38 verbleibt genug Verstellbereich für die beiden Belastungsmaschinen 32, die innerhalb eines ausreichend weiten linearen horizontalen Verstellbereiches unterschiedlich positioniert werden können, um jeweils an diese unterschiedlich dimensionierten Prüflinge 26 angekoppelt zu werden.

Die Verstellbarkeit der Belastungsmaschinen 32 ist jeweils durch Doppelpfeile unterhalb der Symbole für die Belastungsmaschinen 32 angedeutet; damit ist eine horizontale Verschiebbarkeit der Belastungsmaschinen 32 zur Variation ihrer Abstände voneinander ermöglicht. Es können auf diese Weise jeweils gleich lange Abtriebswellen 36 verwendet werden, auch bei unterschiedlich großen Achseinheiten 14, die jeweils Teile des Prüflings 26 sind.

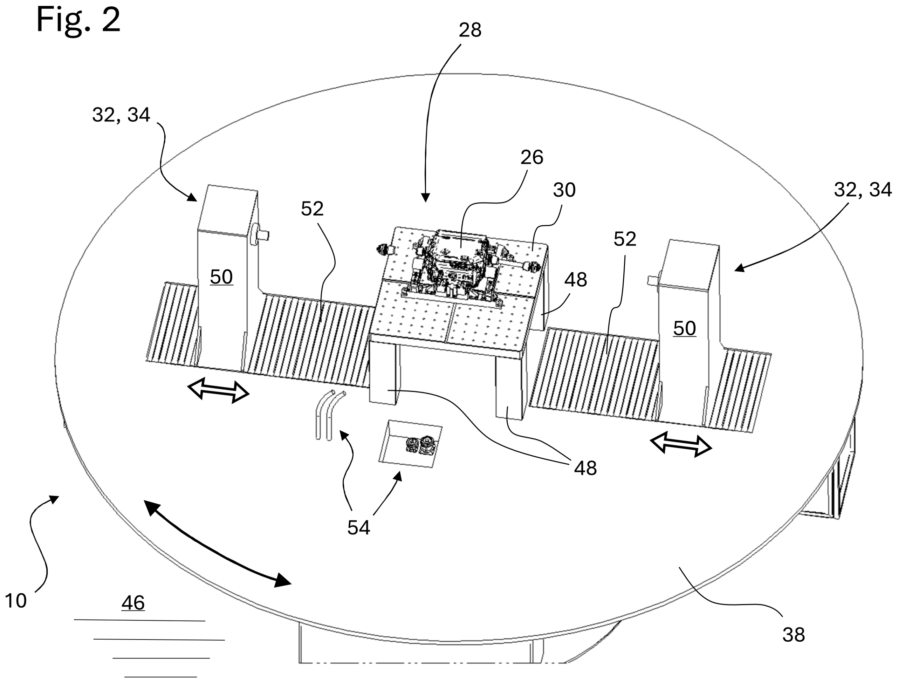

Anhand der Figuren 2 bis 7 soll nachfolgend ein realitätsnahes Ausführungsbeispiel eines solchen Prüfstandes 10 mitsamt seinen typischen Komponenten und ihrer jeweiligen Funktionsweise näher erläutert werden. So zeigt die schematische und perspektivische Darstellung der Fig. 2 den Drehteller 38 oder Drehtisch, der um die vertikale Achse (nicht gezeigt) gedreht werden kann, wobei zur Realisierung jeder gewünschten Position der zu untersuchenden Prüflinge 26 vorzugsweise ein Winkelbereich der Rotation von mindestens 360° sinnvoll sein kann. Um eine gewisse Überdeckung zu ermöglichen, kann der Drehbereich bspw. einen Drehwinkel von ca. 380° oder ggf. noch etwas mehr als 380° abdecken.

Der abgeschirmte äußere Bereich 42 (vgl. Fig. 1) ist hier durch eine Grundplatte oder einen Bodenbereich 46 der abgeschirmten EMV-Halle verdeutlicht. Der Drehteller 38 oder Drehtisch bildet einen inneren Bestandteil dieser Grundplatte oder dieses Bodenbereiches 46, so dass diese Bereiche vorzugsweise stufenlos aneinander anschließen.

Auf dem Prüftisch 30, der als Aufspannplatte für den Prüfling 26 dient und der sich im zentralen Bereich des Drehtellers 38 befindet, ist der Prüfling 26 montiert, bestehend aus Achseinheit 14, Antriebsmotor 22 und Leistungselektronik 24, wie dies zuvor beschrieben wurde (vgl. Fig. 1). Der Prüftisch 30 kann insbesondere mehrere elektrisch nicht leitende Aufstandsfüße 48 aufweisen, mit denen er auf der Oberseite des Drehtellers 38 verankert ist.

Die Fig. 2 lässt zudem die Belastungsmaschinen 32 erkennen, die sich in horizontal auf dem Drehteller 38 verschiebbaren Antriebstürmen 50 befinden, in denen die Elektromotoren 34 für die Belastungssimulation untergebracht sind, welche über die jeweiligen Abtriebswellen 36 (vgl. Fig. 1) mit den Ausgängen der Achseinheit 14 (vgl. Fig. 1) gekoppelt sind.

Die jeweilige horizontale Verschiebbarkeit der beiden Antriebstürme 50 der Belastungsmaschinen 32 mit den darin untergebrachten Elektromotoren 34 sind wiederum durch Doppelpfeile gekennzeichnet. Die Drehbarkeit des Drehtellers 38 um seine vertikale Mittelachse ist zudem durch einen gekrümmten Doppelpfeil verdeutlicht. Im Boden des Drehtellers 38 sind zudem jalousieartige Sektionalabdeckungen 52 erkennbar, die sich zwischen den jeweiligen Belastungs- oder Antriebstürmen 50 und dem Prüftisch 30 befinden; die jalousieartigen Sektionalabdeckungen 52 dienen dafür, die entstehenden Öffnungen im Boden des Drehtellers 38 zu verschließen, die aus einer Verschiebung der Antriebstürme 50 resultieren können.

Die Bezugsziffer 54 bezeichnet zudem eine DC-Versorgungsleitung für den Prüfling 26, die auch bei einer Rotation des Drehtellers 38 für dessen ununterbrochene Versorgung mit Gleichspannung sorgen kann.

In der schematischen Darstellung der Fig. 2 sind die Antriebstürme 50 in ihre jeweiligen Endpositionen für einen maximalen Abstand voneinander bewegt, was insbesondere den benötigten Raum für die Montage des Prüflings 26 auf dem Prüftisch 30 des Prüfplatzes 28 bereitstellen kann. Außerdem kann eine solche Endposition notwendig sein, um breitere Prüflinge 26 wie z.B. elektrische Antriebsachsen von Nutzfahrzeugen aufspannen zu können. Außerdem kann eine solche Endposition sinnvoll sein, um z.B. auch Reduktionsgetriebe zwischen den Antriebstürmen 50 und den Prüfling 26 einbauen zu können.

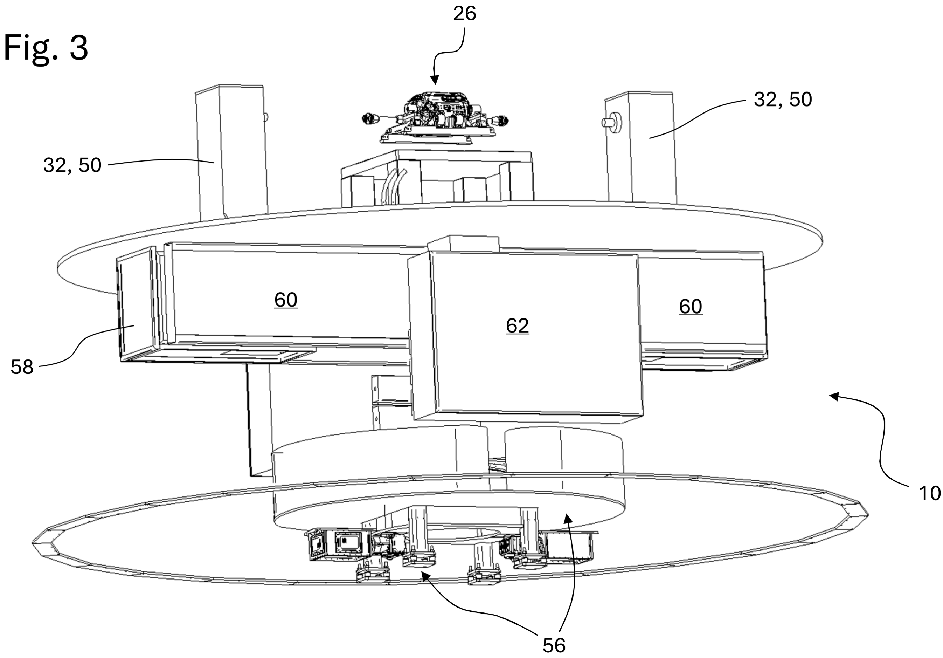

Die schematische und perspektivische Darstellung der Fig. 3 zeigt zudem eine Ansicht von schräg unten und lässt ein Grundgestell 56 mit Drehantrieb erkennen und darüber hinaus einen unterhalb des Drehtellers 38 befindlichen geschirmten Motorkasten 58 für die Belastungsmaschinen 32 (vgl. Figuren 1 und 2). Ein am Drehteller 38 montierter und mit diesem Drehteller 38 mitrotierender Tragrahmen 60 ermöglicht die Verschiebbarkeit der Antriebstürme 50, wie dies oben beschrieben wurde. Weiterhin ist ein ebenfalls unter dem Drehteller 38 angeordneter Antriebsschaltschrank 62 erkennbar, der zur Versorgung der Antriebstürme 50 dient und der EMV-dicht ausgeführt ist.

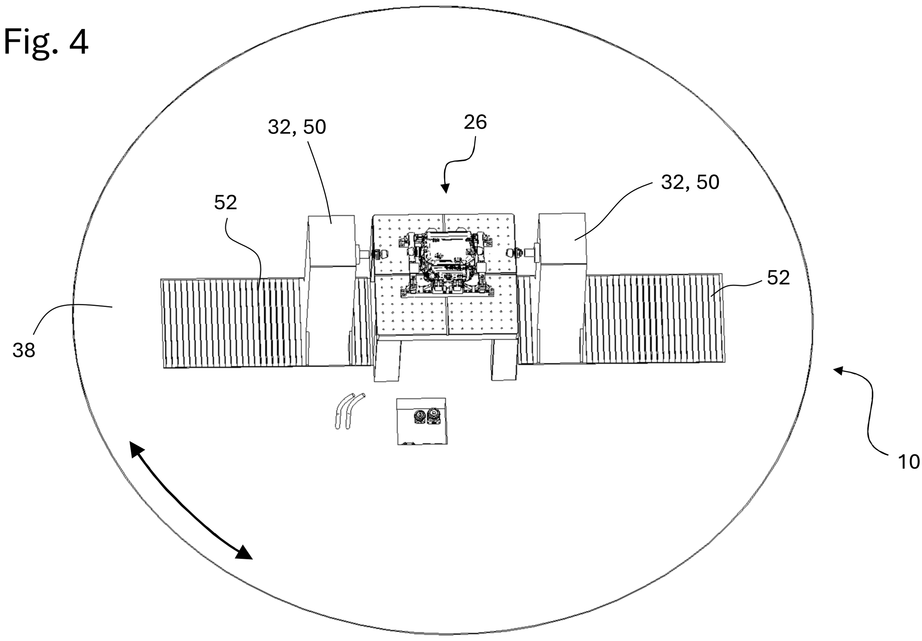

Die schematische und perspektivische Draufsicht der Fig. 4 zeigt weiterhin eine Ansicht von schräg oberhalb des Prüfstandes 10 und lässt die zusammengeschobenen Antriebstürme 50 erkennen, zwischen denen sich ein kompakter Prüfling 26 befindet. Die beiden Antriebstürme 50 mit den Belastungsmaschinen 32 sind hierbei sehr nahe an den Prüfplatz 28 mit dem Prüftisch 30 herangeschoben, so dass hierbei die Sektionalabdeckungen 52 den rückseitigen Bereich der Antriebstürme 50 abdecken.

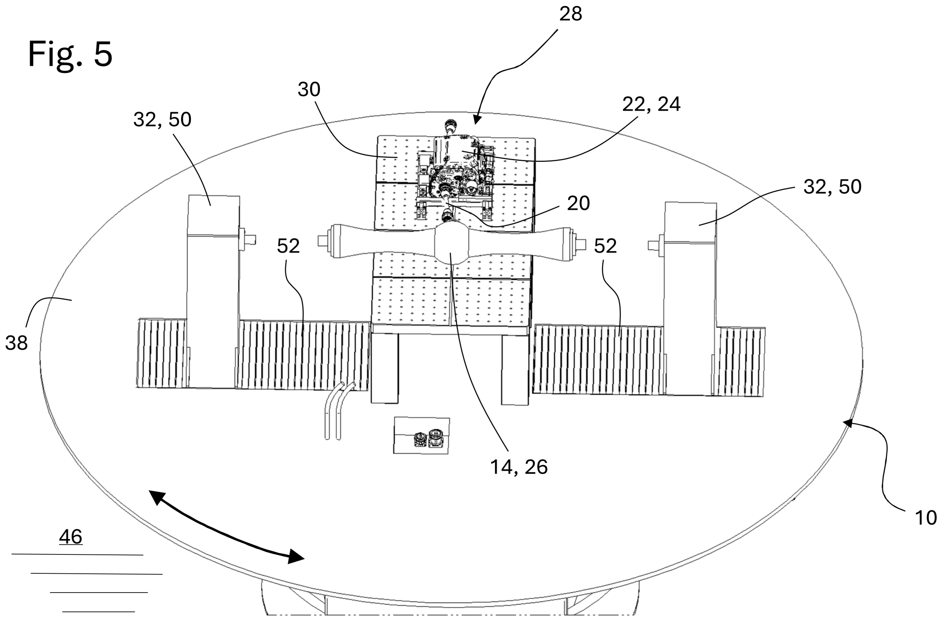

Die schematische und perspektivische Draufsicht der Fig. 5 zeigt schließlich eine weitere Ansicht von schräg oberhalb des Prüfstandes 10 und lässt die auseinanderbewegten Antriebstürme 50 erkennen, zwischen denen sich ein voluminöser Prüfling 26 befindet, der bspw. durch eine Nutzfahrzeug-Achse oder eine Achseinheit 14 einer Baumaschine o. dgl. gebildet sein kann. Diese Achseinheit 14 weist zudem den schon erwähnten elektromotorischen Antrieb 22 auf, der über eine Antriebswelle 20 mit dem Differenzialgetriebe 16 verbunden ist.

Die beiden Antriebstürme 50 mit den Belastungsmaschinen 32 sind hierbei weit voneinander entfernt und vom Prüftisch 30 weggezogen, so dass hierbei die Sektionalabdeckungen 52 den Bereich zwischen Prüfplatz 28 und den jeweiligen Antriebstürmen 50 abdecken.

Die Fig. 5 lässt zudem erkennen, dass der voluminöse Prüfling 26 einen vergrößerten Prüftisch 30 erfordert, der zur Aufnahme des elektromotorischen Antriebes 22 und/oder der damit gekoppelten Leistungselektronik 24 in seiner Fläche vergrößert ist.

Solche Motoreinheiten für LKW, die bspw. als Ersatz eines Verbrennungsmotors betrachtet werden können, haben normalerweise nur einen Wellenabgang. Durch den Aufbau eines nahezu identischen Aufbaus wie im typischen LKW kann die vergleichsweise hohe Leistung und das hohe Drehmoment auf beide Antriebstürme 50 mit ihren Belastungsmaschinen 32 aufgeteilt werden. Der Anbau eines vergrößerten oder zusätzlichen Aufspanntisches (Prüftisch 30) bietet die Möglichkeit, den Prüfaufbau flexibel zu gestalten.

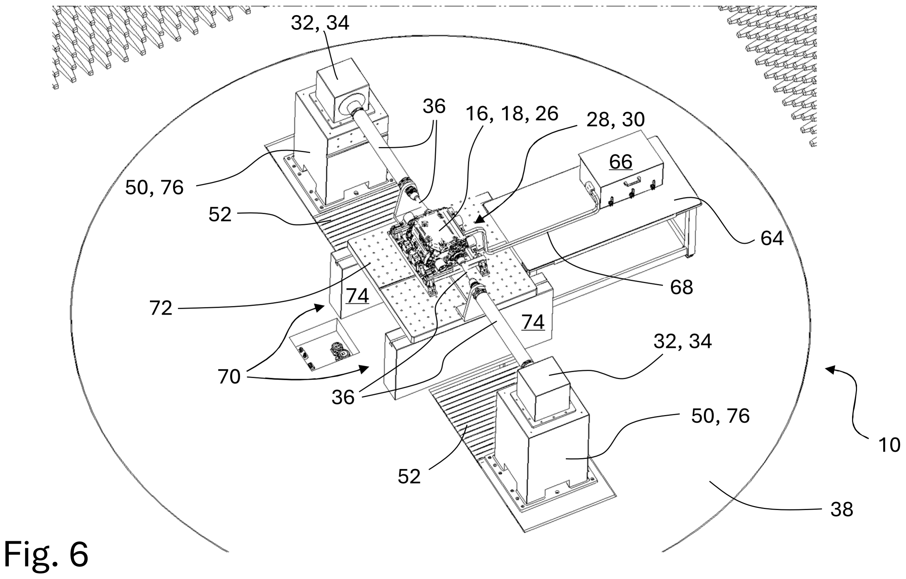

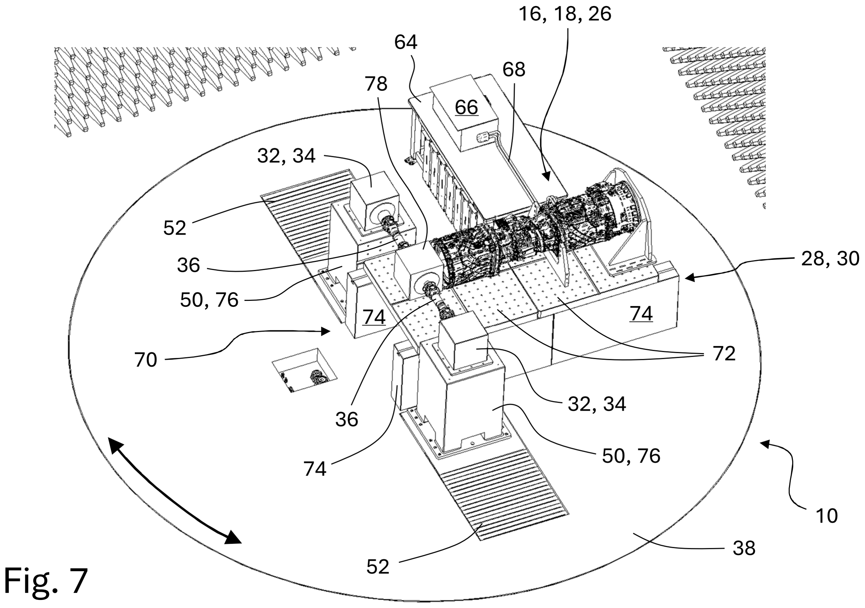

Was in den Figuren 1 bis 5 nicht erkennbar ist, sind weitere Tische, die sich normalerweise neben der Antriebseinheit befinden, um den gesamten Kabelstrang aufzubauen und realitätsnah darzustellen. Diese zusätzlichen Tische können je nach Bedarf vor, hinter oder neben der Antriebseinheit platziert werden, was in den Figuren 6 und 7 beispielhaft verdeutlicht ist.

Normalerweise sind die verwendeten Antennen 40 (vgl. Fig. 1) aufgrund der Leitungsführung zu einem Verstärker oder einem Messaufnehmer ortsgebunden. Sie können jedoch je nach Konfiguration auch ortsveränderlich sein, wenn sich dies als vorteilhaft erweisen sollte. Damit die Prüflinge 26 von verschiedenen Seiten betrachtet und bestrahlt werden können, lassen sie sich mittels des rotierbaren Drehtischs 38 drehen, was mit ortsfesten Antennen 40 zu den gewünschten Messmöglichkeiten führt.

Grundsätzlich zeigt ein Prüfling 26 eine ungleichmäßige Strahlungsverteilung in einem Polarkoordinatendiagramm. Da die Antenne 40 üblicherweise ortsfest und damit immer an der gleichen Stelle ist, lässt sich auch nur diese Stelle messtechnisch betrachten. Eine veränderte Positionierung der Antenne 40 wäre zwar machbar, führt aber zu Problemen hinsichtlich der Leitungsführung und ermöglicht zudem nur eine Betrachtung des Prüflings 26 unter wenigen Winkelgraden. Eine von der Antenne 40 abgewandte Seite ist auf diese Weise noch immer nicht einsehbar. Eine Drehung des Prüflings 26 auf dem Prüftisch 30 wäre zwar denkbar, verursacht jedoch einen unzumutbaren zusätzlichen Arbeits- und Installationsaufwand. Dagegen ermöglicht es der Drehteller 38, den gesamten Tisch 30 mitsamt dem Prüfling 26 in Bezug auf die Antenne 40 zu drehen und somit die Einstellung der unterschiedlichsten Betrachtungswinkel innerhalb sehr kurzer Zeit.

Während die aus dem Stand der Technik bekannten Messaufbauten die Belastungsmaschinen außerhalb der EMV-Halle positionieren und somit auf eine Wellendurchführung durch die Halle angewiesen sind, lässt sich der Prüfling nicht mehr in unterschiedliche Winkelpositionen zur Antenne bringen, was zu einem sehr eingeschränkten Betrachtungsbereich führt. Auch bei der Verwendung von Winkelgetrieben in Kombination mit einer sog. Hallendurchführung ergibt sich zwangsläufig eine feste Position der Winkelgetriebe zueinander. Bei unterschiedlich breiten Prüflingen werden jeweils längenausgleichende Bauteile benötigt. So differieren bereits die Bauteilbreiten von Antriebsachsen von Personenkraftwagen erheblich voneinander, was jeweils Anpassungen notwendig macht. Zudem besteht wiederum der Nachteil einer fixen Position zur Antenne, was unterschiedliche Betrachtungswinkel ausschließt. Zwar hat die Hallendurchführung den Vorteil, dass damit die EMV-störenden Antriebsmaschinen außerhalb der Messumgebung platziert werden können und dadurch kaum Störungen in die EMV-Halle eingeleitet werden.

Ein wesentlicher Nachteil der externen Belastungsmaschinen besteht darin, dass durch die unvermeidlichen Wellendurchführungen die Hallenschirmung durchdrungen werden muss, und dass hier durch ebenfalls Störungen in die Halle eingetragen werden können.

Die damit einhergehenden Nachteile sind allerdings gravierend, so dass die vorliegende Erfindung vorschlägt, die Belastungsmaschinen und die gesamte Antriebstechnik innerhalb der EMV-Halle zu positionieren, auch wenn dies ein Störungspotential mit sich bringt. Allerdings wird dies ausgeglichen durch eine weitestgehende Abschirmung der Motoren und der Leistungselektronik, und zwar in einem Ausmaß, dass keine störenden Strahlungsanteile aus der Abschirmung in die Messumgebung gelangen. Die somit realisierbaren Leistungen können auf dem Drehteller 38 untergebracht werden, wobei das gesamte System in einem Ausmaß geschirmt werden kann, dass die potentiell störenden Komponenten elektromagnetisch neutral bleiben.

Auf diese Weise können Leistungen bis ca. 600 kW oder auch mehr realisiert werden, was im Wesentlichen voraussetzt, dass für die beschriebenen Komponenten ausreichend Platz zur Verfügung steht.

Bei dem erfindungsgemäßen Prüfstand sind Antriebsmotor, Antriebselektronik und notwendige elektrische und elektronische Bauteile allesamt innerhalb der Messkammer in einem geschirmten Körper, so dass keine elektromagnetischen Störungen nach außen und innen gelangt. Der Einbau in einen Drehtisch als Bestandteil des Drehtisches hat den zusätzlichen Grund, dass man die gesamten Bauteile, die schon durch ihre Anwesenheit stören, unterhalb einer Groundplane (Bodenbereich 46) verlegen kann.

Die Figuren 6 und 7 zeigen in schematischen und perspektivischen Darstellungen weitere Ausführungsvarianten des erfindungsgemäßen Prüfstandes 10. So kann der in Fig. 6 gezeigte Prüfling 26 durch eine Getriebeeinheit 18 gebildet sein, wahlweise auch durch ein Differenzialgetriebe 16, dessen fluchtende und gegenüberliegend angeordnete Abtriebswellen 36 jeweils mit separaten Belastungsmaschinen 32 gekoppelt sind. Die Konfiguration entspricht im Wesentlichen derjenigen, wie sie in den Figuren 2 und 4 gezeigt ist, wobei allerdings in der in Fig. 6 gezeigten Ausführungsvariante des Prüfstandes 10 die Abtriebswellen 36 jeweils über Verlängerungen verfügen, wodurch die Belastungsmaschinen 32 jeweils deutlich vom Prüfplatz 28 mit dem darauf befindlichen Prüfling 26 distanziert sind.

Erkennbar sind in Fig. 6 wiederum die oben schon erwähnten jalousieartigen Sektionalabdeckungen 52 im Boden des rotierbaren Drehtellers 38, auf dem weitgehend alle schon oben mehrfach erwähnten Komponenten des Prüfstandes 10 untergebracht sind. Die Antriebstürme 50 für die beiden Elektromotoren 34 der Belastungsmaschinen 32 sind in der Darstellung der Fig. 6 nahezu an ihren äußeren Rand verschoben, d.h. in eine Position eines weitesten Abstandes voneinander.

Die Fig. 6 lässt zudem einen oben erwähnten weiteren Tisch 64 neben dem Prüfplatz 28 erkennen, auf dem sich ein Simulationsmodul 66 für einen Kabelstrang befinden kann. Das in einem geschlossenen Kasten befindliche Simulationsmodul 66 ist über Versorungs- und/oder Signalleitungsverbindungen 68 mit dem Prüfling 26, d.h. mit der Getriebeeinheit 18 oder mit dem Differenzialgetriebe 16 verbunden. Wie es die Figuren 6 und 7 erkennen lassen, kann der weitere Tisch 64 oder ggf. können auch mehrere derartige Tische 64 je nach Bedarf vor, hinter oder neben dem Prüfplatz 28 bzw. dem Prüftisch 30 platziert werden.

Außerdem lässt die Fig. 6 einen Unterbau 70 für den Prüfling 26 erkennen, wobei der Unterbau 70 sowie eine darauf abgestützte horizontale Aufspannplatte 72 im Wesentlichen den oben schon erwähnten Prüftisch 30 bilden. Der Unterbau 70 ist in der Ausführungsvariante gemäß Fig. 6 durch zwei quaderförmige Platten 74 gebildet, die beabstandet voneinander hochkant auf dem Drehteller 38 aufgestellt sind, so dass ihre nach unten weisenden schmalen Längsseiten auf dem Drehteller 38 stehen und ihre nach oben weisenden schmalen Längsseiten jeweils horizontale Auflageflächen für die darauf abgelegte Aufspannplatte 72 zur Verfügung stellen. Diese beiden quaderförmigen Platten 74 bilden somit den Unterbau 70 und bilden gemeinsam mit der darauf abgelegten horizontalen Aufspannplatte 72 den Prüftisch 30.

Die hochkant stehenden quaderförmigen Platten 74 des Unterbaus 70 sind zumindest in wesentlichen Anteilen durch mineralisches Material gebildet oder umfassen zu wesentlichen Anteilen mineralisches Material. Dieses mineralische Material kann bspw. durch Kalkstein wie etwa Marmor, durch Granit, durch Mineralglas oder durch ein geeignetes mineralisches Sinter- oder Gussmaterial gebildet sein, das über die notwendige Stabilität und gleichzeitig für die gewünschte geringe elektromagnetische Permittivität verfügt. D.h. der Unterbau 70, der durch die gezeigten quaderförmigen Platten 74 gebildet sein kann, kann bei der gezeigten Ausführungsvariante der Fig. 6 vorzugsweise aus geeignetem Steinmaterial wie Marmor oder Granit o. dgl. bestehen, wodurch für eine möglichst geringe elektromagnetische Permittivität des stützenden Unterbaus 70 des Prüfplatzes 28 gesorgt ist, so dass sich für diese Teile eine relativ gering ausgeprägte Wechselwirkung mit dem innerhalb des Prüfstandes 10 erzeugten elektromagnetischen Feld ergibt.

Gleiches oder Entsprechendes kann auch für die Antriebstürme 50 der Belastungsmaschinen 32 gelten, die ebenfalls im Wesentlichen aus mineralischem Material bestehen können. So können auch die in Fig. 6 gezeigten Antriebstürme 50, auf denen sich die Elektromotoren 34 der Belastungsmaschinen 32 befinden, jeweils z.B. aus Marmor oder Granit o. dgl. geeignetem Material gefertigt sein, was die genannten Vorteile hinsichtlich der reduzierten elektromagnetischen Permittivität dieser Antriebstürme 50 bieten kann. Sofern die Antriebstürme 50 der Belastungsmaschinen 32 aus mineralischem Material gebildet sind, sollen diese im vorliegenden Zusammenhang auch als Unterbau 76 für die Belastungsmaschinen 32 bezeichnet sein.

Die Aufspannplatte 72 des Prüftischs 30, auf welcher der Prüfling 26 befestigt ist, kann vorzugsweise als elektromagnetisch und elektrisch leitende Grundplatte ausgebildet sein, die somit als elektrisch leitende Erdungsplatte für den Prüfling 26 fungieren kann. So kann der Prüftisch 30, der den Aufspanntisch für den Prüfling 26 bildet, über eine solide Stahlplatte o. dgl. metallische Platte verfügen, welche die Aufspannplatte 72 bildet. Weiterhin kann es von Vorteil sein, wenn diese Aufspannplatte 72 wechselbar auf dem durch mineralisches Material gebildeten Unterbau 70 des Prüftischs 30 befestigt ist, was allfällige Rüstvorgänge beschleunigen und vereinfachen kann.

Außerdem zeigt die schematische und perspektivische Darstellung der Fig. 7 einen größeren Prüfling 26, der durch eine länger bauende Getriebeeinheit 18 gebildet ist, wodurch zwei aneinandergeschobene Prüftische 30 notwendig sind, die jedoch im Wesentlichen dieselbe Größe aus Ausgestaltung aufweisen können, wie dies oben unter Bezugnahme auf die Fig. 6 beschrieben wurde.

Da bei der in Fig. 7 gezeigten Getriebeeinheit 18, die den Prüfling 26 bildet, kein Differenzialgetriebe (vgl. hierzu die Figuren 1 und 5) an der Getriebeeinheit 18 angekoppelt ist, kann ein solches als Bestandteil des Prüfplatzes 28 zur Verfügung gestellt sein, wie es durch die Fig. 7 angedeutet ist. Die beiden Belastungsmaschinen 32 sind hierbei über kürzere Abtriebswellen 36 mit diesem Ersatzgetriebe antriebstechnisch gekoppelt, so dass sie mit minimalem Abstand voneinander nahe an den Prüftisch 30 des Prüfplatzes 28 herangeschoben sind.

Auch die Fig. 7 lässt den oben erwähnten weiteren Tisch 64 neben dem Prüfplatz 28 erkennen, auf dem sich ein Simulationsmodul 66 für einen Kabelstrang befinden kann. Das in einem geschlossenen Kasten befindliche Simulationsmodul 66 ist über Versorungs- und/oder Signalleitungsverbindungen 68 mit dem Prüfling 26, d.h. mit der Getriebeeinheit 18 verbunden.

Der Unterbau 70 für den Prüfling 26 entspricht bis auf seine doppelte Ausführung, die wegen der größeren Getriebeeinheit 18 notwendig ist, im Wesentlichen der oben bereits beschriebenen Variante gemäß Fig. 6. So ist auch hier der Unterbau 70 in der Ausführungsvariante gemäß Fig. 7 durch insgesamt vier quaderförmige Platten 74 gebildet, die paarweise beabstandet voneinander hochkant auf dem Drehteller 38 aufgestellt sind, so dass ihre nach unten weisenden schmalen Längsseiten auf dem Drehteller 38 stehen und ihre nach oben weisenden schmalen Längsseiten jeweils horizontale Auflageflächen für die beiden darauf abgelegten Aufspannplatten 72 zur Verfügung stellen. Jede dieser beiden Paare von quaderförmigen Platten 74 bildet somit einen Teil des Unterbaus 70, und gemeinsam mit den darauf abgelegten horizontalen Aufspannplatten 72 bilden sie den Prüftisch 30.

Wie schon oben erwähnt, können die hochkant stehenden quaderförmigen Platten 74 des Unterbaus 70 bspw. durch Kalkstein, durch Granit oder durch ein geeignetes mineralisches Material gebildet sein, das über die notwendige Stabilität und gleichzeitig für die gewünschte geringe elektromagnetische Permittivität verfügt. Wiederum gilt Gleiches oder Entsprechendes für die gezeigten Antriebstürme 50 der Belastungsmaschinen 32 gelten, die ebenfalls im Wesentlichen aus mineralischem Material bestehen können. So können auch die in Fig. 7 gezeigten Antriebstürme 50, auf denen sich die Elektromotoren 34 der Belastungsmaschinen 32 befinden, jeweils z.B. aus Marmor oder Granit o. dgl. geeignetem Material gefertigt sein, was die genannten Vorteile hinsichtlich der reduzierten elektromagnetischen Permittivität dieser Antriebstürme 50 bieten kann. Auch hier gilt wieder, dass die Antriebstürme 50 der Belastungsmaschinen 32, die aus mineralischem Material gebildet sind, jeweils als Unterbau 76 für die Belastungsmaschinen 32 bezeichnet und in Fig. 7 mit den entsprechenden Bezugsziffern versehen sind.

Die beiden Aufspannplatten 72 des Prüftischs 30, auf welcher der Prüfling 26 befestigt ist, sind als elektromagnetisch und elektrisch leitende Grundplatten ausgebildet, wie dies schon oben unter Bezugnahme auf die Fig. 6 erläutert wurde.

Insbesondere bei der Betrachtung der Fig. 7 ist darauf hinzuweisen, dass der Prüfstand 10 grundsätzlich auch für solche Prüflinge 26 verwendet werden kann, die nur eine einzige Abtriebswelle 36 besitzen. In diesem Fall kann an diese einzige Abtriebswelle 36 wahlweise eine einzige Belastungsmaschine 32 angeschlossen werden, womit im Wesentlichen dieselben Prüfstandsläufe durchgeführt werden können. Durch das in Fig. 7 gezeigte zusätzliche Differenzialgetriebe 78, das in der gezeigten Weise mit dem Prüfling 26 gekoppelt ist, kann der Prüfling 26 über die jeweiligen Abtriebswellen 36 an beide Belastungsmaschinen 32 angeschlossen werden, wodurch auch die Leistung und das Drehmoment beider Belastungsmaschinen 32 abgegriffen werden kann.

Die Getriebeeinheit 18, die zwischen dem Prüfling 26 und dem zusätzlichen Differenzialgetriebe 78 verbaut ist, kann wahlweise dafür vorgesehen und entsprechend ausgestaltet sein, den Drehmoment- und Drehzahlbereich der Belastungsmaschine 32 oder der beiden Belastungsmaschinen 32 flexibel an den jeweiligen Prüfling 26 anzupassen. So können bei niedriger Drehzahl hohe Drehmomente eingeleitet werden, während bei hoher Drehzahl niedrigere Drehmomente eingeleitet werden können.

Die Erfindung wurde unter Bezugnahme auf eine bevorzugte Ausführungsform beschrieben. Es ist jedoch für einen Fachmann vorstellbar, dass Abwandlungen oder Änderungen der Erfindung gemacht werden können, ohne dabei den Schutzbereich der nachstehenden Ansprüche zu verlassen.

### Bezugszeichenliste

- 10: Prüfstand
- 12: Achsantriebsgruppe
- 14: Achseinheit
- 16: Differenzialgetriebe
- 18: Getriebeeinheit
- 20: Antriebswelle
- 22: Antrieb, elektromotorischer Antrieb
- 24: Leistungselektronik
- 26: Prüfling
- 28: Prüfplatz
- 30: Prüftisch
- 32: Belastungsmaschine
- 34: Elektromotor
- 36: Abtriebswelle
- 38: Drehteller
- 40: Antenne
- 42: abgeschirmter räumlicher Bereich
- 44: Abschirmung
- 46: Bodenbereich
- 48: Aufstandsfüße
- 50: Antriebsturm
- 52: Sektionalabdeckung
- 54: Versorgungsleitung
- 56: Grundgestell mit Drehantrieb
- 58: Motorkasten
- 60: Tragrahmen
- 62: Antriebsschaltschrank
- 64: weiterer Tisch
- 66: Simulationsmodul
- 68: Leitungsverbindungen, Versorgungs- und/oder Signalleitungsverbindungen
- 70: Unterbau, Unterbau für den Prüfling
- 72: Aufspannplatte, Grundplatte
- 74: Platten, quaderförmige Platten
- 76: Unterbau, Unterbau für die Belastungsmaschine
- 78: Differenzialgetriebe, zusätzliches Differenzialgetriebe

## Patentansprüche

1. Prüfstand (10) zur Untersuchung der elektromagnetischen Verträglichkeit von Achsantriebsgruppen (12), die zumindest eine auf einem Prüfplatz (28) fixierte angetriebene Achseinheit (14) eines Fahrzeuges mit angebauter Getriebeeinheit (18), einen mit der Achseinheit (14) gekoppelten elektromotorischen Antrieb (22) sowie eine mit diesem gekoppelte Leistungselektronik (24) umfasst, wobei die angetriebene Achseinheit (14) mit der angebauten Getriebeeinheit (18), dem elektromotorischen Antrieb (22) sowie der Leistungselektronik (24) einen Prüfling (26) bildet, dessen elektromagnetische Verträglichkeit auf dem Prüfstand (10) zu untersuchen ist, welcher Prüfstand (10) mitsamt dem Prüfplatz (28) innerhalb eines definierten abgeschirmten räumlichen Bereiches (42) angeordnet ist,
wobei die Achsantriebsgruppe (12) abtriebsseitig mit Belastungsmaschinen (32) zur Simulierung eines Antriebswiderstandes für die Achsantriebsgruppe (12) gekoppelt ist, wobei dem Prüfstand (10) eine Antenne (40) zur Erfassung der elektromagnetischen Emissionen des Prüflings (26) während eines Prüfstandlaufes zugeordnet ist,
und wobei der gesamte Prüfstand (10) mit dem darin angeordneten Prüfplatz (28) und mit dem dort fixierten Prüfling (26) mitsamt den Belastungsmaschinen (32) rotierbar ist, insbesondere in Bezug auf die Antenne (40).

2. Prüfstand (10) nach Anspruch 1, bei dem die Antenne (40) ortsfest innerhalb des abgeschirmten räumlichen Bereiches (42) angeordnet ist.

3. Prüfstand (10) nach Anspruch 1, bei dem die Antenne (40) ortsveränderlich innerhalb des abgeschirmten räumlichen Bereiches (42) angeordnet ist.

4. Prüfstand (10) nach einem der Ansprüche 1 bis 3, der als ganzer gegen elektromagnetische Strahlung abgeschirmt und mitsamt der Schirmung rotierbar ist.

5. Prüfstand (10) nach einem der Ansprüche 1 bis 4, bei dem die Belastungsmaschinen (32) auf dem Prüfstand (10) ortsveränderlich sind und zur Anpassung an unterschiedlich dimensionierte Prüflinge (26) in horizontaler Richtung beweglich sind.

6. Prüfstand (10) nach Anspruch 5, bei dem die Belastungsmaschinen (32) jeweils beidseitig des Prüfplatzes (28) in den Abständen zu diesem veränderlich sind.

7. Prüfstand (10) nach einem der Ansprüche 1 bis 6, bei dem der dem auf dem Prüfplatz (28) befindliche Prüfling (26) mitsamt den Belastungsmaschinen (32) auf einem rotierbaren Drehteller (38) positioniert sind.

8. Prüfstand (10) nach Anspruch 7, bei dem die Belastungsmaschinen (32) sich auf dem rotierbaren Drehteller (38) als ortsveränderliche Teile des Prüfstandes (10) befinden.

9. Prüfstand (10) nach Anspruch 7 oder 8, bei dem die Belastungsmaschinen (32) variabel auf dem Drehteller (38) positionierbar sind, wobei sie insbesondere in ihrem Abstand zueinander und/oder in ihren jeweiligen Abständen zum Prüfplatz (28) veränderlich sind.

10. Prüfstand (10) nach einem der Ansprüche 1 bis 9, bei dem die Belastungsmaschinen (32) weitestgehend gegen elektromagnetische Strahlung geschirmt sind, insbesondere zur Vermeidung von Störungen, die auf die Antenne (40) wirken.

11. Prüfstand (10) nach einem der Ansprüche 1 bis 10, bei dem sich die Leistungselektronik (24) innerhalb der Schirmung befindet und einen Teil des Prüfstandes (10) bildet.

12. Prüfstand (10) nach einem der Ansprüche 1 bis 11, bei dem ein Unterbau des Prüflings (26), welcher Unterbau des Prüflings (26) einen stützenden Bestandteil des Prüfplatzes (28) bildet und welcher Unterbau sich insbesondere zwischen dem Prüfling (26) und dem rotierbaren Drehteller (38) befindet und insbesondere durch Aufstandsfüße (48) o. dgl. gebildet ist, zumindest in wesentlichen Anteilen durch mineralisches Material gebildet ist oder zu wesentlichen Anteilen mineralisches Material umfasst.

13. Prüfstand nach einem der Ansprüche 1 bis 12, bei dem ein Unterbau mindestens einer der Belastungsmaschinen (32), welcher Unterbau der Belastungsmaschine (32) einen stützenden Bestandteil dieser mindestens einen Belastungsmaschine (32) bildet und welcher Unterbau sich insbesondere zwischen der Belastungsmaschine (32) und dem rotierbaren Drehteller (38) befindet und insbesondere durch einen Antriebsturm (50) gebildet ist oder einen Teil dieses Antriebsturmes (50) bildet, zumindest in wesentlichen Anteilen durch mineralisches Material gebildet ist oder zu wesentlichen Anteilen mineralisches Material umfasst.

14. Prüfstand nach einem der Ansprüche 1 bis 13, bei dem der Prüfplatz (28) einen Prüftisch (30) umfasst, auf dem sich der Prüfling (26) befindet, welcher Prüftisch (30) insbesondere über den Unterbau des Prüflings (26) verfügt, wobei der Prüfling (26) auf dem Prüftisch (30) befestigbar oder aufspannbar ist, und wobei der Prüftisch (30) eine elektromagnetisch und elektrisch leitende Grundplatte umfasst.
